# EUROPEAN PATENT APPLICATION

(11) **EP 4 531 417 A1**
(43) Date of publication of application: **02.04.2025**
(21) Application number: 24203129.2
(22) Date of filing: 27.09.2024
(51) Int. Cl.: H04N 25/79, H04N 25/773

(54) **PHOTOELECTRIC CONVERSION APPARATUS, PHOTOELECTRIC CONVERSION SYSTEM, MOVING BODY, AND EQUIPMENT**

(30) Priority: 28.09.2023 JP 2023167272
(71) Applicant: CANON KABUSHIKI KAISHA, Tokyo 146-8501 (JP)
(72) Inventor: OTA, Yasuharu, Tokyo, 146-8501 (JP); MORIMOTO, Kazuhiro, Tokyo, 146-8501 (JP)
(74) Representative: TBK

(57) **Abstract**

A photoelectric conversion apparatus includes a pixel having an avalanche photodiode, a pixel circuit, and a signal processing circuit, and a control signal generation circuit that generates a first control signal to control an operation of the pixel circuit and a second control signal to control an operation of the signal processing circuit. A second circuit layer where the signal processing circuit and the control signal generation circuit are arranged, a first circuit layer where the pixel circuit is arranged, and a photodiode layer where the avalanche photodiode is arranged are laminated together in this order, an output terminal of the avalanche photodiode is connected to the pixel circuit, the control signal generation circuit is arranged in a peripheral region around the pixel region, and first wiring is provided on the first circuit layer, the first wiring being connected to the control signal generation circuit.

## Description

### BACKGROUND

### Technical Field

The technology of the present disclosure relates to a photoelectric conversion apparatus, a photoelectric conversion system, a moving body, and equipment.

### Description of the Related Art

Photoelectric conversion apparatuses capable of detecting single-photon-level weak light using avalanche multiplication have been known. U.S. Patent Application Publication No. 2017/0186798 discloses a photoelectric conversion apparatus in which both a sensor chip with a plurality of pixels arrayed thereon and a circuit chip with a circuit that performs signal processing are electrically connected in a stacked structure.

It is disclosed that, in the pixels inside the sensor chip of this photoelectric, avalanche diodes, in which charges cause avalanche multiplication, are used conversion apparatus.

Japanese Patent Application Laid-open No. 2022-113123 proposes the configuration of a photoelectric conversion apparatus having a structure of at least three layers including avalanche photodiodes.

However, in the structures of the photoelectric conversion apparatuses described in U.S. Patent Application Publication No. 2017/0186798 and Japanese Patent Application Laid-open No. 2022-113123, there is room for studying microfabrication of circuits in circuit layers stacked on a photodiode layer.

The technology of the present disclosure has been made in view of the above problem to provide a technology for supporting microfabrication of circuits in a photoelectric conversion apparatus having a structure of at least three layers.

### SUMMARY

According to some embodiments, it is provided a photoelectric conversion apparatus as specified in claims 1 to 12. In addition, it is provided a photoelectric conversion system as specified in claim 13, a moving body as specified in claim 14, and equipment as specified in claim 15.

Further features of the present invention will become apparent from the following description of exemplary embodiments with reference to the attached drawings.

### BRIEF DESCRIPTION OF THE DRAWINGS

FIG. 1 is a schematic diagram of a photoelectric conversion apparatus according to embodiments.
FIG. 2 is a schematic diagram of a photodiode layer in the photoelectric conversion apparatus according to the embodiments.
FIG. 3 is a schematic diagram of a first circuit layer in the photoelectric conversion apparatus according to the embodiments.
FIG. 4 is a schematic diagram of a second circuit layer in the photoelectric conversion apparatus according to the embodiments.
FIGS. 5A and 5B are diagrams schematically illustrating the driving of photodiodes in the photoelectric conversion apparatus according to the embodiments.
FIG. 6 is a schematic diagram illustrating the circuit configuration of a photoelectric conversion apparatus according to a first embodiment.
FIG. 7 is a schematic diagram illustrating the circuit configuration of a photoelectric conversion apparatus according to a related art.
FIG. 8 is a schematic diagram illustrating the circuit configuration of a photoelectric conversion apparatus according to a modification of the first embodiment.
FIG. 9 is a schematic diagram illustrating the circuit configuration of a photoelectric conversion apparatus according to a second embodiment.
FIG. 10 is a schematic diagram illustrating the circuit configuration of a photoelectric conversion apparatus according to a third embodiment;
FIG. 11 is a diagram illustrating a photoelectric conversion system according to a fourth embodiment.
FIGS. 12A and 12B are diagrams illustrating a photoelectric conversion system and a moving body according to a fifth embodiment.
FIG. 13 is a diagram illustrating a distance image sensor according to a sixth embodiment.
FIG. 14 is a diagram illustrating an endoscopic surgery system according to a seventh embodiment.
FIGS. 15A and 15B are diagrams illustrating a smart glass according to an eighth embodiment.
FIGS. 16A and 16B are diagrams illustrating electronic equipment according to a ninth embodiment.
FIG. 17 is a diagram illustrating an X-ray CT apparatus according to a tenth embodiment.
FIG. 18 is a diagram illustrating equipment according to an eleventh embodiment.

### DESCRIPTION OF THE EMBODIMENTS

Hereinafter, embodiments according to the technology of the present disclosure will be described in detail on the basis of the drawings. The following embodiments intend to materialize the technical idea of the present disclosure, and do not intend to limit the technology of the present disclosure. The sizes or positional relationships of members illustrated in the respective drawings may be exaggerated for clarity. In the following descriptions, the same configurations may be indicated by the same symbols, and their duplicated descriptions will be omitted in some cases.

In the present specification, a plan view refers to viewing from a direction perpendicular to the light-incident surface of a semiconductor layer. Further, a cross-sectional view refers to viewing from a direction parallel to the light-incident surface of the semiconductor layer. Note that when the light-incident surface of the semiconductor layer is a coarse surface from a microscopic perspective, the plan view is defined using the light-incident surface of the semiconductor layer as viewed in a macroscopic perspective as a reference. The constituting elements of the respective embodiments may be added to another embodiment, or may be replaced with the constituting elements of another embodiment. Further, the sizes or positional relationships of the members illustrated in the respective drawings may be exaggerated for clarity in some cases.

The following embodiments relate to photoelectric conversion apparatuses including Single Photon Avalanche Diodes (SPADs) that count the number of photons particularly incident on avalanche photodiodes. The photoelectric conversion apparatuses include at least avalanche photodiodes. Further, in the photoelectric conversion apparatuses that will be described in the following respective embodiments, the anodes of the avalanche photodiodes (APD) are set to a fixed potential, and signals are taken from the cathode side. Accordingly, a first conductive type semiconductor region where charges with the same polarity as that of signal charges serve as majority carriers refers to an N-type semiconductor region. Conversely, a second conductive type semiconductor region where charges with a polarity different from that of the signal charges serve as majority carriers refers to a P-type semiconductor region.

Note that the following respective embodiments are also applicable to a case where the cathodes of APDs are set to a fixed potential and signals are taken from the anode side. In this case, a first conductive type semiconductor region where charges with the same polarity as that of signal charges serve as majority carriers refers to a P-type semiconductor region. Conversely, a second conductive type semiconductor region where charges with a polarity different from that of the signal charges serve as majority carriers refers to an N-type semiconductor region. Cases where one node of APDs is set to a fixed potential will be described below, but the potentials of both nodes may fluctuate.

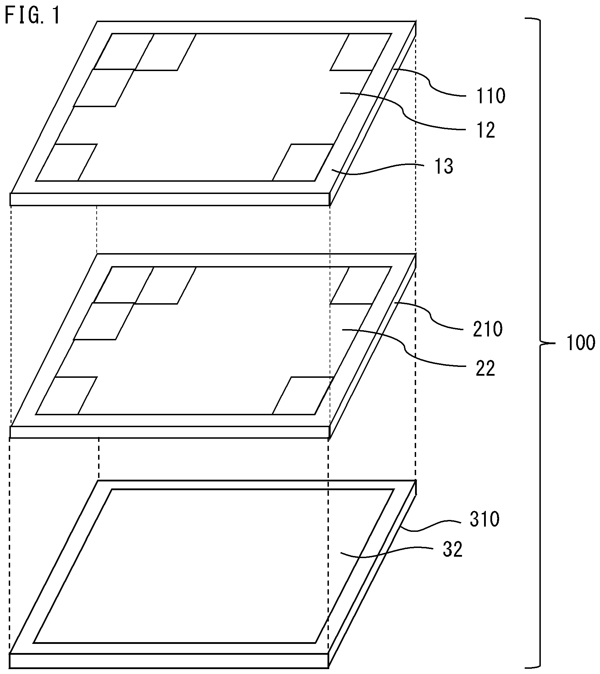

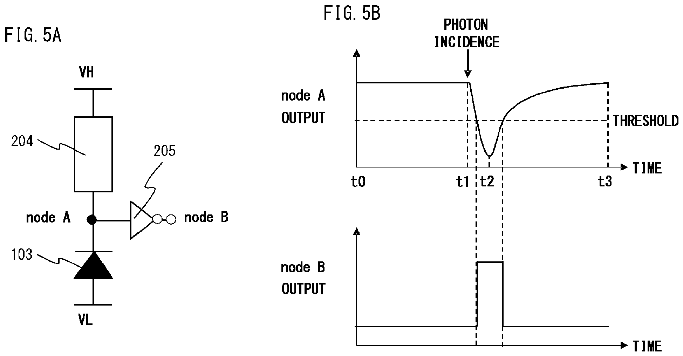

First, the configurations of a photoelectric conversion apparatus and a driving method therefor that are common to the respective embodiments will be described using FIG. 1 to FIGS. 5A and 5B.

FIG. 1 is a diagram illustrating an entire image of a photoelectric conversion apparatus 100. The photoelectric conversion apparatus 100 is configured with a first substrate 110, a second substrate 210, and a third substrate 310 laminated together. The first substrate 110 is also called a sensor chip, and has a pixel region 12 where pixels having a photoelectric conversion unit are two-dimensionally arrayed. Further, a peripheral region 13 is provided between the pixel region 12 and the chip end of the photoelectric conversion apparatus 100. The second substrate 210 is also called a pixel circuit chip, and has a pixel circuit region 22 where pixel control circuits that process signals from the photoelectric conversion units are arranged. The third substrate 310 is also called a signal processing chip, and has a signal processing circuit region 32 where signal processing circuits that process signals from the pixel control circuits are arranged.

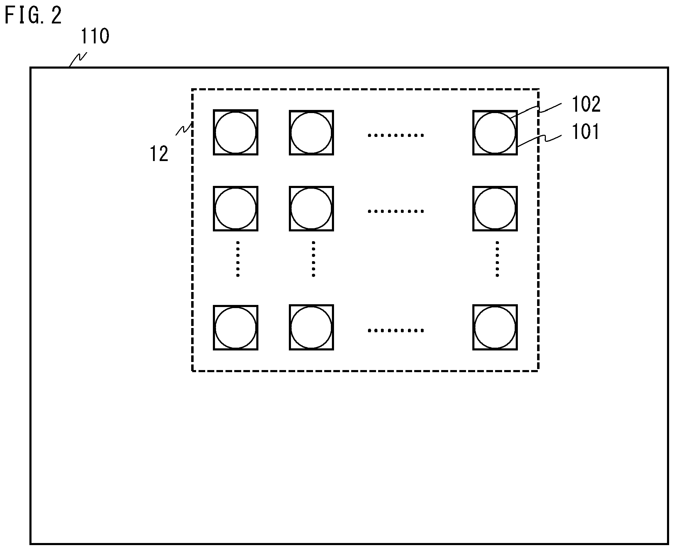

(First Substrate) FIG. 2 is a configuration diagram of the first substrate 110. On the first substrate 110, the pixel region 12 where the pixels 101 having the photoelectric conversion unit 102 including an avalanche photodiode (hereinafter, APD) are two-dimensionally arrayed is provided. Note that the pixels 101 may also be one-dimensionally arrayed in the pixel region 12. Further, the details of the photoelectric conversion unit 102 will be described later.

The pixels 101 serve as pixels typically used to form images. However, when used in Time of Flight (TOF), the pixels 101 may not necessarily form images. That is, the pixels 101 may also serve as elements used to measure the time at which light has reached and the amount of light.

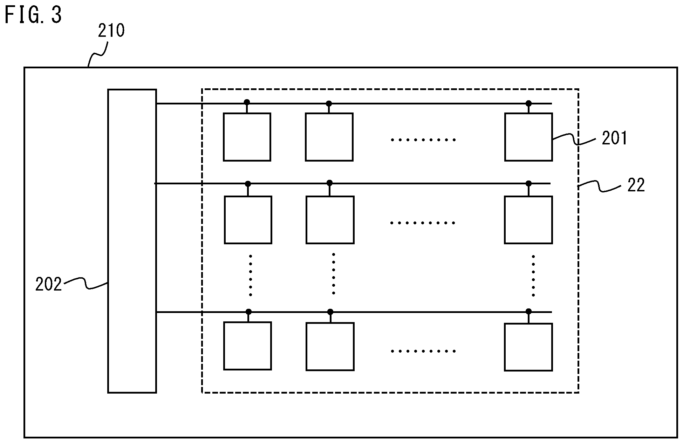

(Second Substrate) FIG. 3 is a configuration diagram of the second substrate 210. The second substrate 210 has pixel control circuits 201 and a vertical scanning circuit 202. A pixel circuit region 22 where at least the pixel control circuits 201 are provided is arranged at the position overlapping the pixel region 12 on the first substrate 110 illustrated in FIG. 2. The pixel control circuits 201 are electrically connected to the photoelectric conversion units 102 on the first substrate 110 through connection wiring provided for each pixel. Also, the pixel control circuits 201 are electrically connected to signal processing circuits 301 on the third substrate 310 through connection wiring. The pixel control circuits 201 serve as pixel circuits that perform processing using signals output from the photoelectric conversion units 102 of the pixels. For example, the pixel control circuits 201 perform processing such as quenching operations for the avalanche photodiodes of the photoelectric conversion units 102 and waveform shaping for signals output from the photoelectric conversion units 102.

The vertical scanning circuit 202 receives pixel control signals (also called pixel clocks (PCLK)) supplied from a control signal generation circuit 302 on the third substrate 310, and supplies pixel control signals to the respective pixel control circuits 201. Logic circuits such as shift registers and address decoders are used for the vertical scanning circuit 202.

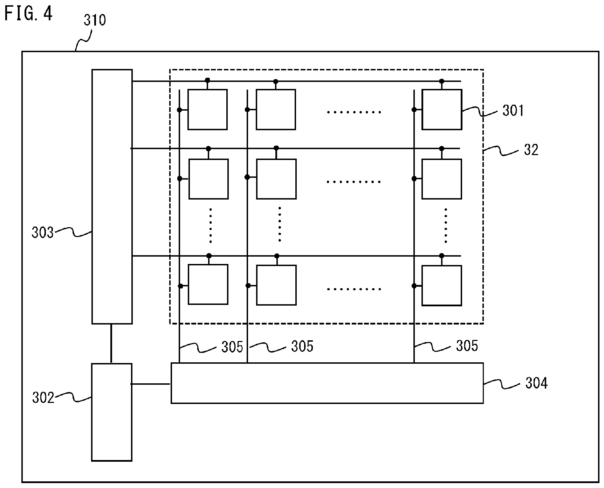

(Third Substrate) FIG. 4 is a configuration diagram of the third substrate 310. The third substrate 310 has the signal processing circuits 301, the control signal generation circuit 302, a vertical scanning circuit 303, a horizontal scanning circuit 304, and signal lines 305. The signal processing circuit region 32 where at least the signal processing circuits 301 are provided is arranged at the position overlapping the pixel region 12 on the first substrate 110 illustrated in FIG. 2 and the pixel circuit region 22 on the second substrate 210 illustrated in FIG. 3.

The signal processing circuits 301 perform processing using signals output from the pixel control circuits 201. For example, each of the signal processing circuits 301 has a count circuit that performs count processing for pulse signals output from the pixel control circuits 201, a memory that retains count values output from the count circuit, or the like. The vertical scanning circuit 303 receives control signals supplied from the control signal generation circuit 302, and supplies the control signals to the respective signal processing circuits 301. The horizontal scanning circuit 304 inputs control pulses for sequentially selecting respective columns to the signal processing circuits 301 through the signal lines 305 to read signals from the signal processing circuits 301.

Note that the third substrate 310 may be provided with a processing circuit that performs image processing for signals read out from the signal processing circuits 301 or performs processing such as noise reduction and white-balance adjustment for image data. Further, when the photoelectric conversion apparatus 100 is used as a distance measurement apparatus, a processing circuit may be, for example, provided that generates a histogram on the basis of a Time-to-Digital Converter (TDC) circuit or information derived from the TDC circuit and then performs distance calculation.

The histogram depicts the horizontal axis as time-related classes (bins) and the vertical axis as the frequency within each class. The frequency represents the number of times at which light is received during a prescribed light-receiving period. Further, counts based on reflected light and ambient light coexist in the histogram. Therefore, a count based on a reflected-light component and a count based on an ambient-light component are separated by setting a prescribed threshold. Using a light arrival time corresponding to the reflected-light component, the distance between the distance measurement apparatus and an object to be measured is calculated.

Further, the third substrate 310 may be provided with a Digital Signal Processor (DSP) that functions as a processing unit to perform a program stored in a memory and perform various processing using a learned model created by machine learning. For example, the learned model is created by machine learning using a Deep Neural Network (DNN). For example, the learned model may be designed on the basis of parameters generated by inputting learning data to a prescribed machine learning model, where an input signal corresponding to an output from the pixel region 12 is associated with a label for the input signal. Further, the prescribed machine learning model may also be a learning model using a multilayered neural network.

Data output from the photoelectric conversion apparatus 100 is input to an application processor (not illustrated) that processes displays, user interfaces, or the like. This application processor is configured using, for example, a Central Processing Unit (CPU) or the like, and performs an operating system, various application software, or the like. The application processor may also be equipped with the function of a Graphics Processing Unit (GPU), base band processor, or the like. The application processor may perform various processing as needed, perform displays for users, or transmit information to external cloud servers via prescribed networks for input image data or calculation results.

The networks may include various networks such as the Internet, a wired Local Area Network (LAN), a wireless LAN, a mobile communication network, and Bluetooth (TM). Further, the transmission destinations of the image data or calculation results are not limited to cloud servers but may include various information processing apparatuses (systems) having communication functions, such as servers that operate alone, file servers that store and manage various data, and communication terminals such as mobile phones.

FIGS. 5A and 5B are diagrams schematically illustrating the relationship between the operations of the APDs of the photoelectric conversion units 102 and an output signal. As illustrated in FIG. 5A, an APD 103 of the photoelectric conversion unit 102 is electrically connected to a quenching element 204 and a waveform shaping unit 205 of the pixel control circuit 201 in one pixel of the photoelectric conversion apparatus 100. Here, the input side of the waveform shaping unit 205 serves as a node A, and the output side thereof serves as a node B. FIG. 5B illustrates an example of the waveform change of the node A in FIG. 5A and an example of the waveform change of the node B in FIG. 5A.

As illustrated in FIG. 5B, a potential difference VH - VL is applied to the APD 103 in FIG. 5A between time t0 and time t1. When a photon is incident on the APD 103 at the time 11, avalanche multiplication occurs in the APD 103, causing an avalanche multiplication current to flow to the quenching element 204. As a result, the voltage of the node A drops and exceeds a determination threshold. Then, when the voltage drop amount further increases and the potential difference applied to the APD 103 decreases, the avalanche multiplication in the APD 103 stops at the time t2, and the voltage level of the node A does not drop below at least a certain fixed value. After that, between the time t2 and the time t3, a current flows to the node A to compensate for the voltage drop from the voltage VL, causing the voltage of the node A to rise and exceed the determination threshold. Then, at the time t3, the node A stabilizes at the original potential level. At this time, the portion of the output waveform at the node A that has exceeded a certain threshold is waveform-shaped by the waveform shaping unit 205, and then output as a signal from the node B.

### First Embodiment

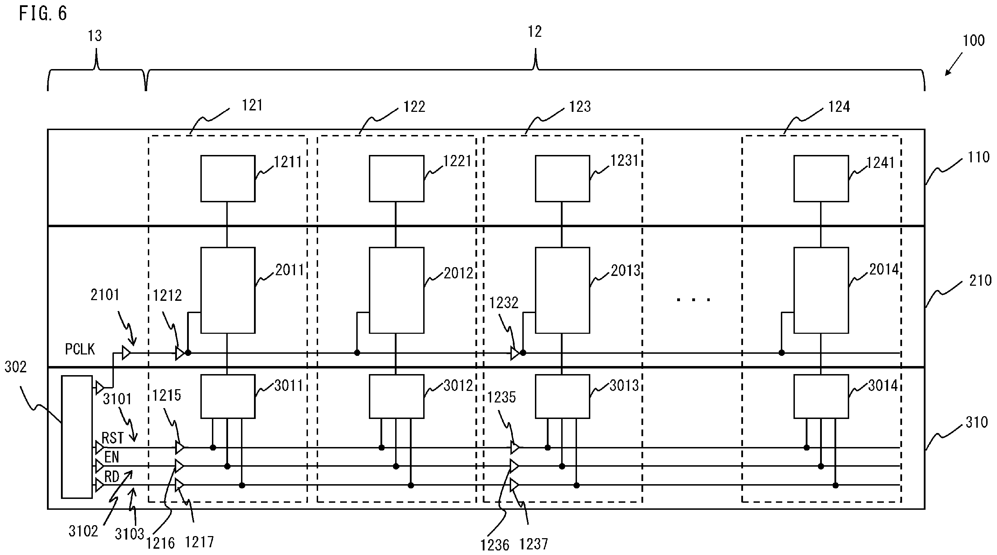

Next, a photoelectric conversion apparatus according to a first embodiment will be described using FIG. 6. FIG. 6 is a block diagram illustrating a circuit example of a photoelectric conversion apparatus 100 according to the present embodiment. Note that some of the constituting elements of the photoelectric conversion apparatus 100 are omitted in the illustration.

As illustrated in FIG. 6, the photoelectric conversion apparatus 100 includes a first substrate 110 serving as a Photo Diode (PD) layer, a second substrate 210 serving as a first circuit layer, and a third substrate 310 serving as a second circuit layer. Accordingly, in the photoelectric conversion apparatus 100, the second circuit layer (third substrate 310), the first circuit layer (second substrate 210), and the photodiode layer (first substrate 110) are laminated together in this order. Further, the side where the first substrate 110 is present serves as the side where light is incident on the photoelectric conversion apparatus 100. In a pixel region 12 of the photoelectric conversion apparatus 100, pixels 121, 122, 123, and 124 are arranged. Note that the four pixels are arranged in one direction in FIG. 6, but pixels having the same configuration as that of these pixels are two-dimensionally arranged in the pixel region 12.

As illustrated in FIG. 6, APDs 1211, 1221, 1231, and 1241 are provided in the pixels 121, 122, 123, and 124, respectively, on the first substrate 110. Further, the pixels 121, 122, 123, and 124 include pixel control circuits 2011, 2012, 2013, and 2014, respectively, on the second substrate 210. The pixel control circuits 2011, 2012, 2013, and 2014 perform operation control for the APDs 1211, 1221, 1231, and 1241 or signal processing for signals output from the APDs 1211, 1221, 1231, and 1241.

The second substrate 210 serves as a substrate where elements such as quenching elements, which have higher pressure resistance than elements arranged on the third substrate, are arranged. Further, in FIG. 6, wiring 2101 that supplies control signals (PCLK) to the pixel control circuits 2011, 2012, 2013, and 2014 is provided on the second substrate 210. The wiring 2101 is provided on the second substrate 210 in the pixel region 12. The wiring 2101 serves as first wiring that supplies first control signals for controlling the operations of pixel circuits to the pixel circuits.

Further, buffers 1212 and 1232 that perform timing adjustment or the like for the control signals transmitted by the wiring 2101 are provided in the pixels 121 and 123, respectively. On the wiring 2101, the buffers 1212 and 1232 are provided at a fixed pitch corresponding to a pixel unit. However, on the wiring 2101, it is permissible to appropriately determine which pixels the buffers are provided for at the fixed pitch. In the present embodiment, a plurality of pixels include at least one pixel where a buffer is not provided on the wiring 2101 and at least one pixel where a buffer is provided on the wiring 2101. Further, the wiring 2101 is connected to a control signal generation circuit 302 on the third substrate 310 in a peripheral region 13.

The third substrate 310 serves as a substrate where elements such as count circuits and logic circuits of memory circuits, which have lower pressure resistance than the elements arranged on the second substrate 210, are arranged. In FIG. 6, the control signal generation circuit 302 is provided in the peripheral region 13 on the third substrate 310 as an example. Further, the pixels 121, 122, 123, and 124 include signal processing circuits 3011, 3012, 3013, and 3014, respectively, on the third substrate 310. The signal processing circuits 3011, 3012, 3013, and 3014 perform count processing using signals output from the pixel control circuits 2011, 2012, 2013, and 2014.

Further, wiring 3101 that supplies reset signals for count circuits to the signal processing circuits 3011, 3012, 3013, and 3014 is provided on the third substrate 310. Further, wiring 3102 that supplies enabling signals for the count circuits to the signal processing circuits 3011, 3012, 3013, and 3014 is provided on the third substrate 310. Further, wiring 3103 that supplies read-out signals for count values to the signal processing circuits 3011, 3012, 3013, and 3014 is provided on the third substrate 310. The wirings 3101, 3102, and 3103 serve as second wiring that supplies second control signals for controlling the operations of the signal processing circuits to the signal processing circuits.

Further, in the pixel 121, buffers 1215, 1216, and 1217 that perform timing adjustment or the like for the control signals transmitted by the wirings 3101, 3102, and 3103 are provided. Similarly, in the pixel 123, buffers 1235, 1236, and 1237 that perform timing adjustment or the like for the control signals transmitted by the wirings 3101, 3102, and 3103 are provided. Note that it is permissible to appropriately determine which pixels the buffers 1215, 1216, 1217, 1235, 1236, and 1237 are provided for. In other words, the pitches at which these respective buffers are provided may differ from each other on the third substrate 310.

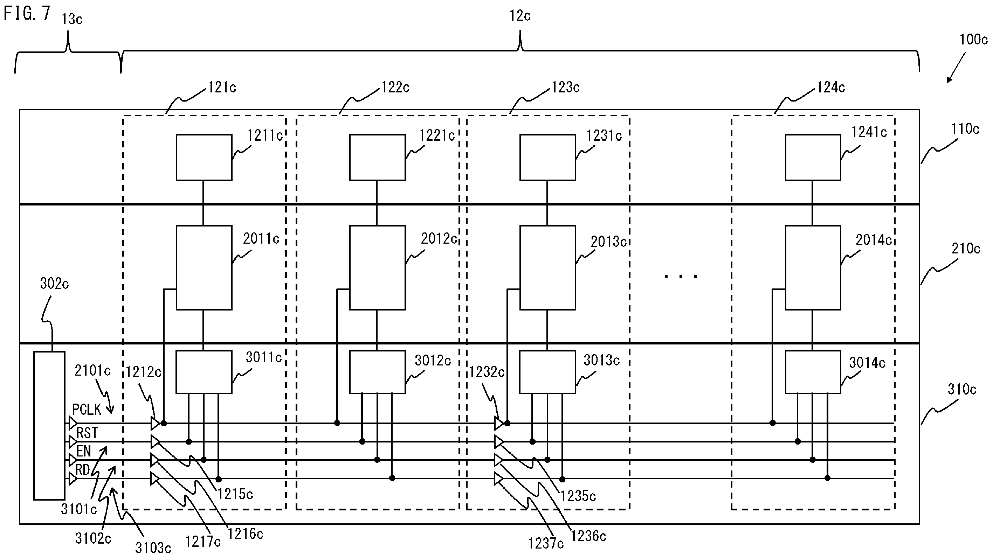

Here, FIG. 7 illustrates an example of a photoelectric conversion apparatus 100c according to a related art. The photoelectric conversion apparatus 100c includes a first substrate 1 10c, a second substrate 210c, and a third substrate 3 10c. Further, pixels 121c, 122c, 123c, and 124c are arranged in a pixel region 12c of the photoelectric conversion apparatus 100c. Note that the four pixels are arranged in one direction in FIG. 7, but pixels having the same configuration as that of these pixels are two-dimensionally arranged in the pixel region 12c. Further, a control signal generation circuit 302c is provided in a peripheral region 13c of the photoelectric conversion apparatus 100c.

The pixels 121c, 122c, 123c, and 124c include APDs 1211c, 1221c, 1231c, and 1241c, pixel control circuits 2011c, 2012c, 2013c, and 2014c, and signal processing circuits 3011c, 3012c, 3013c, and 3014c, respectively. Note that the APDs, pixel control circuits, and signal processing circuits in FIG. 7 correspond to the APDs, pixel control circuits, and signal processing circuits in FIG. 6, respectively. Further, the pixel 121c includes buffers 1212c, 1215c, 1216c, and 1217c, and the pixel 123c includes buffers 1232c, 1235c, 1236c, and 1237c. The buffers 1212c, 1215c, 1216c, 1217c, 1232c, 1235c, 1236c, and 1237c in FIG. 7 correspond to the buffers 1212, 1215, 1216, 1217, 1232, 1235, 1236, and 1237 in FIG. 6, respectively.

In the photoelectric conversion apparatus 100c, wiring 2101c that supplies control signals (PCLK) to the pixel control circuits 2011c, 2012c, 2013c, and 2014c is provided on the third substrate 310c. Further, wirings 3101c, 3102c, and 3103c corresponding to the wirings 3101, 3102, and 3103 in FIG. 6, respectively, are provided on the third substrate 310c like the above photoelectric conversion apparatus 100.

Therefore, on the third substrate 310c of the photoelectric conversion apparatus 100c, the arrangement density of elements and wiring is increased compared to the third substrate 310 of the photoelectric conversion apparatus 100, potentially reducing the number of elements capable of being arranged in the respective pixels in the pixel region. Further, in order to supply control signals to the pixel control circuits 2011c, 2012c, 2013c, and 2014c, it is necessary to provide wiring for transmitting the signals between the third substrate 310c and the second substrate 210c in the respective pixels. Therefore, in the photoelectric conversion apparatus 100c, the connection pitch between the third substrate 310c and the second substrate 210c becomes denser, potentially reducing the number of elements capable of being arranged in the respective pixels in the pixel region.

On the other hand, according to the photoelectric conversion apparatus 100 of the present embodiment, the wiring 2101 for the signals supplied to the pixel control circuits 2011, 2012, 2013, and 2014 provided on the second substrate 210 is provided on the second substrate 210 rather than being provided on the third substrate 310. As described above, when the circuits that process the signals from the APDs 1211, 1221, 1231, and 1241 are provided on the second substrate 210, the wiring that supplies the control signals to the circuits is not provided on the third substrate 310 but is provided on the same second substrate 210. As a result, it is possible to ensure a larger area to provide wiring, elements, or the like on the third substrate 310, and achieve further microfabrication of the constituting elements of the third substrate 310.

### Modification 1

Next, a modification of the photoelectric conversion apparatus 100 according to the first embodiment will be described. Note that the same configurations as those of the above photoelectric conversion apparatus 100 will be indicated by the same symbols, and their detailed descriptions will be omitted below.

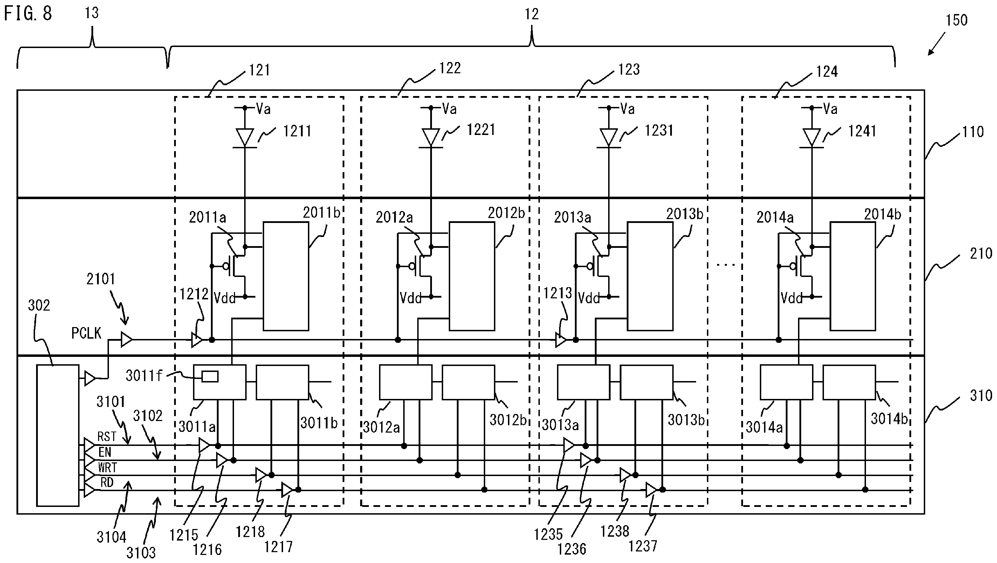

FIG. 8 is a block diagram illustrating a circuit example of a photoelectric conversion apparatus 150 according to the present modification. Note that some of the constituting elements of the photoelectric conversion apparatus 150 are omitted in FIG. 8. As illustrated in FIG. 8, pixels 121, 122, 123, and 124 are provided in a pixel region 12 on a first substrate 110 of the photoelectric conversion apparatus 150. Further, the pixels 121, 122, 123, and 124 include APDs 1211, 1221, 1231, and 1241, respectively. A voltage Va is applied to the anode terminals of the APDs 1211, 1221, 1231, and 1241. The cathode terminals of the APDs 1211, 1221, 1231, and 1241 are connected to Metal-oxide Semiconductor Field Effect Transistors (MOSFETs) 2011a, 2012a, 2013a, and 2014a serving as quenching elements on a second substrate 210.

On the second substrate 210 of the photoelectric conversion apparatus 150, the MOSFETs 2011a, 2012a, 2013a, and 2014a constituting pixel control circuits are provided in the pixel region 12. The drains of the MOSFETs 2011a, 2012a, 2013a, and 2014a are connected to the cathode terminals of the APDs 1211, 1221, 1231, and 1241, respectively. Further, a voltage Vdd is applied to the sources of the MOSFETs 2011a, 2012a, 2013a, and 2014a. The MOSFETs 2011a, 2012a, 2013a, and 2014a perform quenching operations to suppress the voltage supplied to the APDs 1211, 1221, 1231, and 1241, thereby suppressing avalanche multiplication. Further, in the pixel region 12, processing circuits 2011b, 2012b, 2013b, and 2014b including a waveform shaping circuit that performs waveform shaping processing for signals output from the APDs 1211, 1221, 1231, and 1241 are provided.

The APDs 1211, 1221, 1231, and 1241 generate pairs of charges corresponding to incident light through photoelectric conversion. One of the two nodes of the APDs 1211, 1221, 1231, and 1241 is connected to a power supply line through which the driving voltage Va (first voltage) is supplied. Further, the other of the two nodes of the APDs 1211, 1221, 1231, and 1241 is connected to a power supply line through which the driving voltage Vdd (second voltage) higher than the voltage Va supplied to the anodes is supplied.

In FIG. 8, one node of the APDs 1211, 1221, 1231, and 1241 serves as an anode terminal, and the other node thereof serves as a cathode terminal. A reverse bias voltage, which enables the APDs 1211, 1221, 1231, and 1241 to perform avalanche multiplication, is supplied to the anode terminals and the cathode terminals of the APDs 1211, 1221, 1231, and 1241. By creating a state where such a voltage is supplied, charges generated by incident light cause avalanche multiplication, resulting in the occurrence of an avalanche current. In FIG. 8, the cathode terminals serving as the output terminals of the APDs 1211, 1221, 1231, and 1241 are connected to the MOSFETs 2011a, 2012a, 2013a, and 2014a constituting the pixel control circuits. However, the anode terminals of the APDs 1211, 1221, 1231, and 1241 may also be connected to the MOSFETs 2011a, 2012a, 2013a, and 2014a as output terminals.

Note that there is a Geiger mode where, when the reverse bias voltage is supplied, the APDs 1211, 1221, 1231, and 1241 operate with a voltage difference between the anode terminals and the cathode terminals that is greater than the breakdown voltage. Further, there is a linear mode where, when the reverse bias voltage is supplied, the APDs 1211, 1221, 1231, and 1241 operate with a voltage difference between the anode terminals and the cathode terminals that is close to or not more than the breakdown voltage.

The APDs operating in the Geiger mode are called SPADs. For example, the voltage Va is - 30 V, and the voltage Vdd is 1 V. The APDs 1211, 1221, 1231, and 1241 may operate in the linear mode or the Geiger mode. In the case of the SPADs, the voltage difference becomes greater compared to the APDs in the linear mode, resulting in a significant pressure resistance effect. Therefore, the APDs 1211, 1221, 1231, and 1241 preferably serve as the SPADs.

Further, on the second substrate 210, wiring 2101 that supplies control signals (PCLK) to the gates of the MOSFETs 2011a, 2012a, 2013a, and 2014a is provided in a peripheral region 13. Therefore, the MOSFETs 2011a, 2012a, 2013a, and 2014a serving as the quenching elements are controlled by the control signals supplied through the wiring 2101 to switch between a high-resistance state and a low-resistance state where the resistance value is lower than that of the high-resistance state.

On a third substrate 310, a control signal generation circuit 302 is provided in the peripheral region 13. Further, on the third substrate 310, the pixels 121, 122, 123, and 124 include count circuits 3011a, 3012a, 3013a, and 3014a constituting signal processing circuits and memory circuits 3011b, 3012b, 3013b, and 3014b, respectively. Further, the count circuit 3011a includes a flip-flop 3011f to perform count processing for a signal output from the processing circuit 2011b. Note that the count circuits 3012a, 3013a, and 3014a also include the same flip-flop as that of the flip-flop 3011f

Further, wiring 3101 that supplies reset signals to the count circuits 3011a, 3012a, 3013a, and 3014a is provided on the third substrate 310. Further, wiring 3102 that supplies enabling signals to the count circuits 3011a, 3012a, 3013a, and 3014a is provided on the third substrate 310. Further, wiring 3104 that supplies writing signals for writing count values output from the count circuits 3011a, 3012a, 3013a, and 3014a into the memory circuits 3011b, 3012b, 3013b, and 3014b is provided on the third substrate 310. Further, wiring 3103 that supplies read-out signals for count values to the memory circuits 3011b, 3012b, 3013b, and 3014b is provided on the third substrate 310. The wirings 3101, 3102, 3103, and 3104 serve as second wiring that supplies second control signals for controlling the operations of the signal processing circuits to the signal processing circuits.

In the pixel 121, buffers 1215, 1216, 1217, and 1218 that perform timing adjustment or the like for the control signals transmitted by the wirings 3101, 3102, 3103, and 3104 are provided. Similarly, in the pixel 123, buffers 1235, 1236, 1237, and 1238 that perform timing adjustment or the like for the control signals transmitted by the wirings 3101, 3102, 3103, and 3104 are provided. Note that it is permissible to appropriately determine which pixels the buffers 1215, 1216, 1217, 1218, 1235, 1236, 1237, and 1238 are provided for. In other words, the pitches at which these respective buffers are provided may differ from each other on the third substrate 310.

According to the photoelectric conversion apparatus 150 of the present modification, the wiring 2101 for the signals supplied to the MOSFETs 2011a, 2012a, 2013a, and 2014a provided on the second substrate 210 is provided on the second substrate 210 rather than being provided on the third substrate 310. As a result, it is possible to ensure a larger area to provide wiring, elements, or the like on the third substrate 310, and achieve further microfabrication of the constituting elements of the third substrate 310.

### Second Embodiment

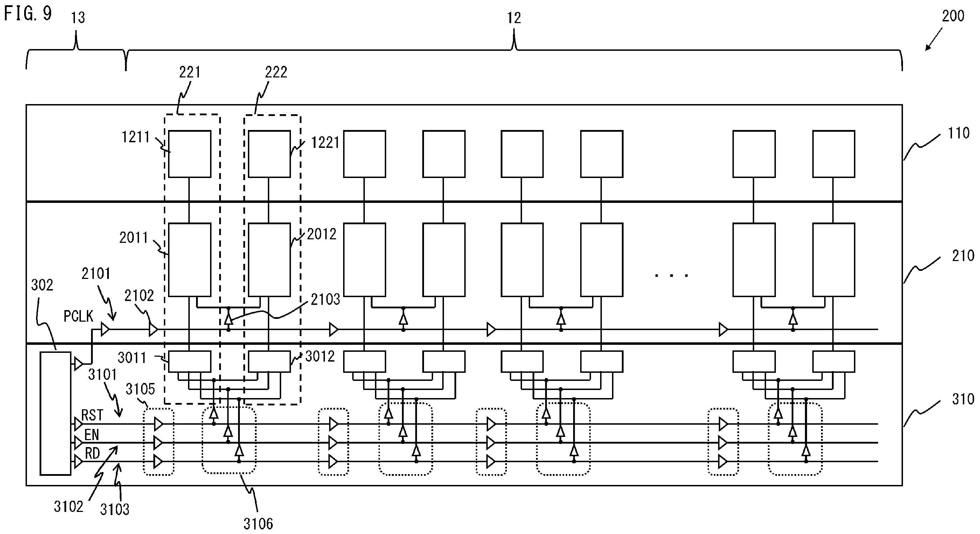

Next, a photoelectric conversion apparatus according to a second embodiment will be described using FIG. 9. Note that the same configurations as those of the above embodiment will be indicated by the same symbols, and their detailed descriptions will be omitted below.

FIG. 9 is a block diagram illustrating a circuit example of a photoelectric conversion apparatus 200 according to the present embodiment. Note that some of the constituting elements of the photoelectric conversion apparatus 200 are omitted in FIG. 9. As illustrated in FIG. 9, the photoelectric conversion apparatus 200 includes a first substrate 110, a second substrate 210, and a third substrate 310.

On the first substrate 110, pixels 221 and 222 are provided in a pixel region 12. Note that a plurality of pixels having the same configuration as that of the pixels 221 and 222 are two-dimensionally arranged in the pixel region 12. However, the pixels 221 and 222 will be described, and descriptions of other pixels will be omitted below. The pixels 221 and 222 include APDs 1211 and 1221, pixel control circuits 2011 and 2012 connected to the APDs 1211 and 1221, and signal processing circuits 3011 and 3012 connected to the pixel control circuits 2011 and 2012, respectively.

In a peripheral region 13 on the second substrate 210, wiring 2101 that supplies control signals (PCLK) to the pixel control circuits 2011 and 2012 is provided. Further, in the pixel region 12 on the second substrate 210, a buffer 2102 serving as a global buffer that performs timing adjustment for the transmission speeds or the like of the control signals transmitted by the wiring 2101 is provided. Moreover, in the pixel region 12 on the second substrate 210, a buffer 2103 serving as a local buffer that transmits the control signals transmitted via the buffer 2102 to the pixel control circuits 2011 and 2012 is provided. The buffer 2102 serves as a first buffer that outputs first control signals to a plurality of groups each including at least two pixels among the plurality of pixels. Further, the buffer 2103 serves as a second buffer that outputs the first control signals to the respective pixels included in the plurality of groups.

Further, a control signal generation circuit 302 is provided in the peripheral region 13 on the third substrate 310. Further, the pixels 221 and 222 include the signal processing circuits 3011 and 3012, respectively, on the third substrate 310. Moreover, wirings 3101, 3102, and 3103 are provided on the third substrate 310.

Further, in the present embodiment, buffers 3105 serving as global buffers that perform timing adjustment or the like for the transmission speeds of signals transmitted by the wirings 3101, 3102, and 3103 are provided. Further, buffers 3106 serving as local buffers that supply the signals transmitted by the wirings 3101, 3102, and 3103 to the signal processing circuits 3011 and 3012 are provided on the third substrate 310.

Note that, as illustrated in FIG. 9, the buffers 2102, 2103, 3105, and 3106 are provided for the group of the pixels 221 and 222 in the present embodiment. However, it is permissible to appropriately determine which pixels these buffers are provided for. In other words, the pitches at which these respective buffers are provided may differ from each other on the second substrate 210 and the third substrate 310.

The farther the pixels are from the buffers 2102 and 3105, the greater the delay of supplied signals becomes. For this reason, if only the buffers 2102 and 3105 attempt to perform timing adjustment for the transmission speeds or the like of the signals to the respective pixels in the pixel region 12, the configurations of the buffers 2102 and 3105 may become complicated. Therefore, in the photoelectric conversion apparatus 200 of the present embodiment, the buffers 2102, 2103, 3105, and 3106 are provided for the group of the pixels 221 and 222. As a result, a burden on the signal processing of the buffers 2102 and 3105 is distributed, enabling a reduction in the delay of the control signals supplied to the respective pixels.

Further, according to the photoelectric conversion apparatus 200 of the present embodiment, the wiring 2101 for the signals supplied to the pixel control circuits 2011 and 2012 provided on the second substrate 210 is provided on the second substrate 210 rather than being provided on the third substrate 310. As described above, when the circuits that process the signals from the APDs 1211 and 1221 are provided on the second substrate 210, the wiring that supplies the control signals to the circuits is not provided on the third substrate 310 but is provided on the same second substrate 210. As a result, it is possible to ensure a larger area to provide wiring, elements, or the like on the third substrate 310, and achieve further microfabrication of the constituting elements of the third substrate 310.

### Third Embodiment

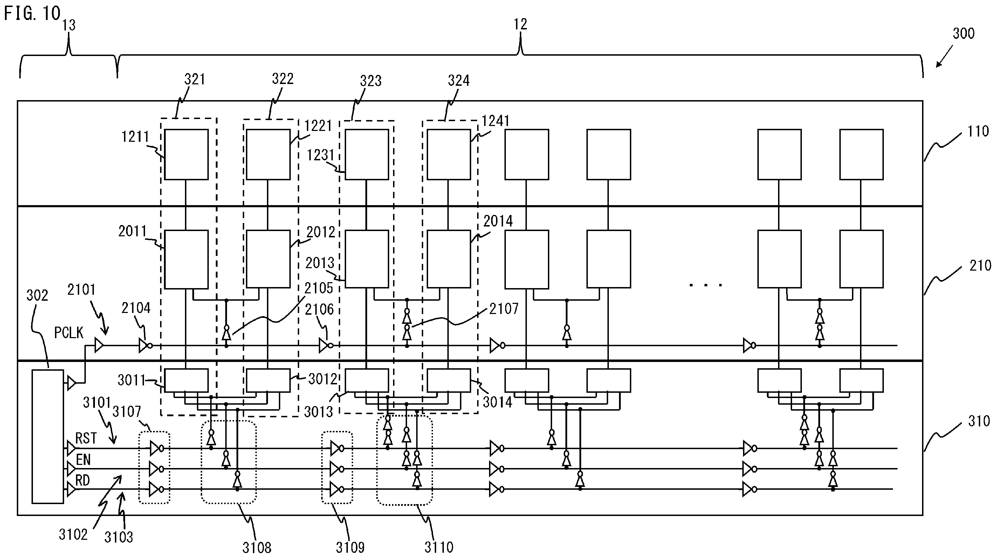

Next, a photoelectric conversion apparatus according to a third embodiment will be described using FIG. 10. Note that the same configurations as those of the above embodiments will be indicated by the same symbols, and their detailed descriptions will be omitted below.

FIG. 10 is a block diagram illustrating a circuit example of a photoelectric conversion apparatus 300 according to the present embodiment. Note that some of the constituting elements of the photoelectric conversion apparatus 300 are omitted in FIG. 10. As illustrated in FIG. 10, the photoelectric conversion apparatus 300 includes a first substrate 110, a second substrate 210, and a third substrate 310.

On the first substrate 110, pixels 321, 322, 323, and 324 are provided in a pixel region 12. Note that a plurality of pixels having the same configuration as that of the pixels 321, 322, 323, and 324 are two-dimensionally arranged in the pixel region 12. However, the pixels 321, 322, 323, and 324 will be described, and descriptions of other pixels will be omitted below. The pixels 321, 322, 323, and 324 include APDs 1211, 1221, 1231, and 1241 and pixel control circuits 2011, 2012, 2013, and 2014 connected to the APDs 1211, 1221, 1231, and 1241, respectively. Further, the pixels 321, 322, 323, and 324 include signal processing circuits 3011, 3012, 3013, and 3014 connected to the pixel control circuits 2011, 2012, 2013, and 2014, respectively.

In a peripheral region 13 on the second substrate 210, wiring 2101 that supplies control signals (PCLK) to the pixel control circuits 2011, 2012, 2013, and 2014 is provided. Further, in the pixel region 12 on the second substrate 210, a buffer 2104 serving as a global buffer that performs timing adjustment for the transmission speeds or the like of the control signals transmitted by the wiring 2101 is provided. Moreover, in the pixel region 12 on the second substrate 210, a buffer 2105 serving as a local buffer that transmits the control signals transmitted via the buffer 2104 to the pixel control circuits 2011 and 2012 is provided. Similarly, in the pixel region 12 on the second substrate 210 a buffer 2106 serving as a global buffer that performs timing adjustment for the transmission speeds or the like of the control signals output from the buffer 2104 is provided. Moreover, in the pixel region 12 on the second substrate 210, a buffer 2107 serving as a local buffer that transmits the control signals transmitted via the buffer 2106 to the pixel control circuits 2013 and 2014 is provided.

In the present embodiment, the buffers 2104, 2105, 2106, and 2107 are configured as combined logic circuits, each including a pair of a buffer and an inverter. Further, the buffer 2107 has two pairs of a buffer and an inverter connected in series. Accordingly, the buffer 2104 serving as a first buffer has a logic circuit that inverts an input first control signal. Thus, the pulse waveforms of the control signals transmitted by the wiring 2101 are inverted by the buffers 2104 and 2105, and then supplied to the pixel control circuits 2011 and 2012. Further, the control signals output from the buffer 2104 are inverted by the buffer 2106, and further inverted twice by the buffer 2107 and supplied to the pixel control circuits 2013 and 2014.

In the photoelectric conversion apparatus 200 of the second embodiment, the buffers 2102 and 2103 are configured as positive logic circuits. Therefore, in the wiring 2101, delay in the rising or falling of the pulses of the transmitted control signals accumulates, leading to the possibility of the deformation of the pulse waveforms of the control signals. On the other hand, in the photoelectric conversion apparatus 300 of the present embodiment, the delay in the rising and falling of the pulses of the control signals alternates every time the control signals are inverted in the buffers 2104 and 2106. As a result, the buffers 2104 and 2106 are capable of outputting the control signals without deforming the pulse waveforms of the input control signals.

In the photoelectric conversion apparatus 300, control signals output from a control signal generation circuit 302 are inverted by the buffer 2104. Therefore, the signals are inverted again by the buffer 2105 and then supplied to the pixel control circuits 2011 and 2012. Further, the control signals output from the buffer 2104 are inverted again by the buffer 2106. That is, the control signals output from the control signal generation circuit 302 become non-inverted. Accordingly, the control signals output from the buffer 2106 are inverted twice by the buffer 2107 and then supplied to the pixel control circuits 2013 and 2014.

On the third substrate 310, the control signal generation circuit 302 is provided in the peripheral region 13. Further, the pixels 321, 322, 323, and 324 include the signal processing circuits 3011, 3012, 3013, and 3014, respectively, on the third substrate 310. Moreover, wirings 3101, 3102, and 3103 are provided on the third substrate 310.

Further, in the present embodiment, buffers 3107 and 3109 serving as global buffers that perform timing adjustment for the transmission speeds or the like of signals transmitted by the wirings 3101, 3102, and 3103 are provided. Further, buffers 3108 serving as local buffers that supply the signals transmitted by the wirings 3101, 3102, and 3103 to the signal processing circuits 3011 and 3012 are provided on the third substrate 310. Similarly, buffers 3110 serving as local buffers that supply the respective signals output from the buffers 3107 to signal processing circuits 3013 and 3014 are provided.

Note that inversion by the buffers 3107, 3108, 3109, and 3110 for the respective signals is the same as the above inversion by the buffers 2104, 2105, 2106, and 2107 for the control signals transmitted by the wiring 2101, and therefore its detailed description will be omitted here.

Further, as illustrated in FIG. 10, the buffers 3107 and 3108 are provided for the group of the pixels 321 and 322, and the buffers 3109 and 3110 are provided for the group of the pixels 323 and 324 in the present embodiment. However, it is permissible to appropriately determine which pixels these buffers are provided for. In other words, the pitches at which these respective buffers are provided may differ from each other on the third substrate 310.

According to the photoelectric conversion apparatus 300 of the present embodiment, the buffers 3107 and 3108 are provided for the group of the pixels 321 and 322, and the buffers 3109 and 3110 are provided for the group of the pixels 323 and 324. As a result, a burden on the signal processing of the buffers 2104 and 3107 is distributed, enabling a reduction in the delay of the control signals supplied to the respective pixels.

Further, according to the photoelectric conversion apparatus 300 of the present embodiment, the wiring 2101 for the signals supplied to the pixel control circuits 2011, 2012, 2013, and 2014 provided on the second substrate 210 is provided on the second substrate 210 rather than being provided on the third substrate 310. As described above, when the circuits that process the signals from the APDs 1211, 1221, 1231, and 1241 are provided on the second substrate 210, the wiring that supplies the control signals to the circuits is not provided on the third substrate 310 but is provided on the same second substrate 210. As a result, it is possible to ensure a larger area to provide wiring, elements, or the like on the third substrate 310, and achieve further microfabrication of the constituting elements of the third substrate 310.

### Fourth Embodiment

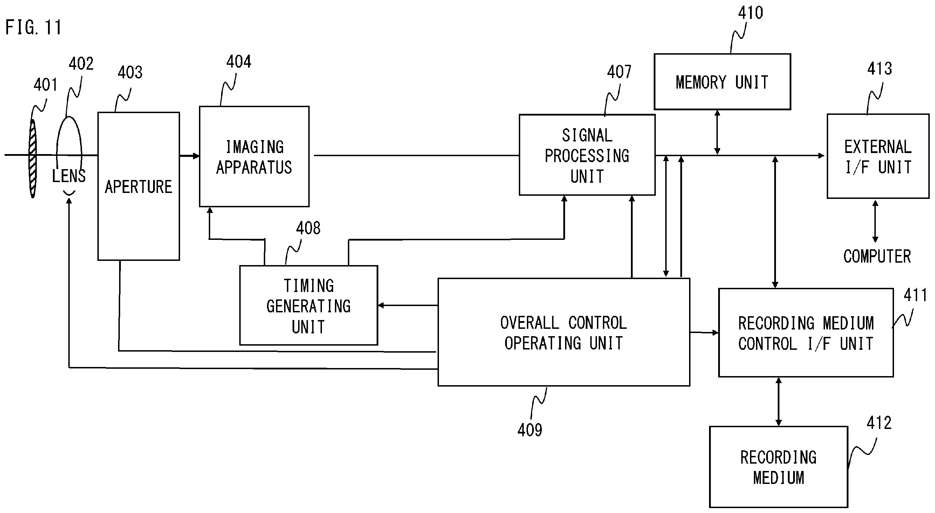

A photoelectric conversion system according to the present embodiment will be described using FIG. 11. FIG. 11 is a block diagram illustrating the schematic configuration of the photoelectric conversion system according to the present embodiment.

The photoelectric conversion apparatuses described in the first to third embodiments are applicable to various photoelectric conversion systems. The photoelectric conversion systems include at least the photoelectric conversion apparatuses according to the above embodiments and a signal processing unit that processes signals output from the photoelectric conversion apparatuses. Examples of equipment to which such photoelectric conversion systems are applicable include digital still cameras, digital cam coders, monitoring cameras, copiers, facsimile machines, mobile phones, in-vehicle cameras, observation satellites, sensors, and measuring instruments. Further, camera modules including optical systems such as lenses and imaging apparatuses are also included in the equipment to which the photoelectric conversion systems are applied. FIG. 11 illustrates a block diagram of a digital still camera as an example of these equipment.

The photoelectric conversion system illustrated in FIG. 11 has an imaging apparatus 404 that is an example of a photoelectric conversion apparatus, a lens 402 for forming optical images of a subject on the imaging apparatus 404, an aperture 403 for making the amount of light passing through the lens 402 variable, and a barrier 401 for protecting the lens 402. The lens 402 and the aperture 403 refer to optical systems that focus light onto the imaging apparatus 404. The imaging apparatus 404 refers to the photoelectric conversion apparatus according to any of the above embodiments and converts optical images formed by the lens 402 into electric signals.

The photoelectric conversion system also has a signal processing unit 407 serving as an image generation unit that performs processing for output signals output from the imaging apparatus 404 to generate images. The signal processing unit 407 performs various corrections and compression as needed and outputs image data. The signal processing unit 407 may be formed on the same semiconductor substrate as the imaging apparatus 404, or may be formed on a semiconductor substrate different from the semiconductor substrate on which the imaging apparatus 404 is provided. Further, the imaging apparatus 404 and the signal processing unit 407 may also be formed on the same semiconductor substrate.

The photoelectric conversion system also has a memory unit 410 for temporarily storing image data, and an external interface unit (external I/F unit) 413 for communicating with external computers or the like. Moreover, the photoelectric conversion system has a recording medium 412 such as a semiconductor memory for performing recording or reading of imaging data, and a recording medium control interface unit (recording medium control I/F unit) 411 for performing recording in or reading from the recording medium 412. Note that the recording medium 412 may be embedded in the photoelectric conversion system, or may be detachable.

Furthermore, the photoelectric conversion system has an entire control and calculation unit 409 that controls various calculation and the entire digital still camera, and a timing generation unit 408 that outputs various timing signals to the imaging apparatus 404 and the signal processing unit 407. Here, the timing signals or the like may be input from the outside, and the photoelectric conversion system may only have at least the imaging apparatus 404 and the signal processing unit 407 that processes output signals output from the imaging apparatus 404.

The imaging apparatus 404 outputs imaging signals to the signal processing unit 407. The signal processing unit 407 applies prescribed signal processing to the imaging signals output from the imaging apparatus 404 and outputs image data. The signal processing unit 407 generates images using the imaging signals.

As described above, according to the present embodiment, it is possible to realize the photoelectric conversion system to which the photoelectric conversion apparatus (imaging apparatus) according to any of the above embodiments is applied.

### Fifth Embodiment

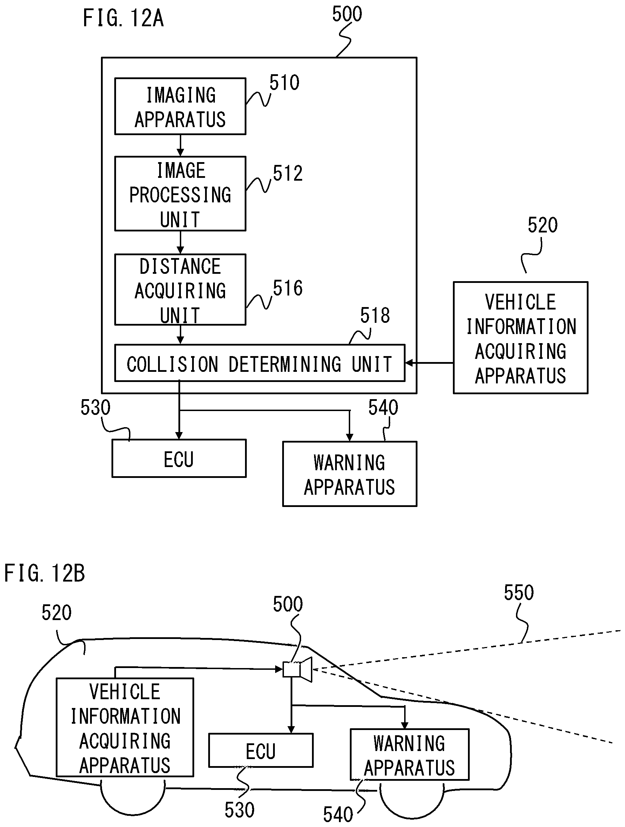

A photoelectric conversion system and a moving body according to the present embodiment will be described with reference to FIGS. 12A and 12B. FIG. 12A is a diagram showing a configuration of the photoelectric conversion system according to the present embodiment and FIG. 12B is a diagram showing a configuration of the moving body according to the present embodiment.

FIG. 12A shows an example of a photoelectric conversion system related to a vehicle-mounted camera. A photoelectric conversion system 500 includes an imaging apparatus 510 to which the photoelectric conversion apparatus described in any one of the embodiments described above is applied. The photoelectric conversion system 500 has an image processing unit 512 that performs image processing on a plurality of pieces of image data acquired by the imaging apparatus 510. In addition, the photoelectric conversion system 500 has a distance acquiring unit 516 that calculates a distance to an object and a collision determining unit 518 that determines whether or not there is a possibility of a collision based on the calculated distance. In this case, the distance acquiring unit 516 may acquire information on the distance to the object based on a ToF (Time of Flight) or may acquire distance information using parallax information or the like. Furthermore, the distance acquiring unit 516 may acquire distance information by combining ranging according to ToF and ranging based on a phase difference between pixels. In other words, distance information is information related to a parallax, a defocus amount, a distance to the object, or the like. The collision determining unit 518 may determine a possibility of a collision using any of these pieces of distance information. The distance information acquiring unit may be realized by exclusively-designed hardware or may be realized by a software module. Alternatively, the distance information acquiring unit may be realized by an FPGA (Field Programmable Gate Array), an ASIC (Application Specific Integrated Circuit), or the like, or a combination thereof.

The photoelectric conversion system 500 is connected to a vehicle information acquiring apparatus 520 and is capable of acquiring vehicle information such as a vehicle speed, a yaw rate, and a steering angle. In addition, an ECU 530 which is a control apparatus that outputs a control signal causing a vehicle to generate a braking force based on a determination result of the collision determining unit 518 is connected to the photoelectric conversion system 500. Furthermore, the photoelectric conversion system 500 is also connected to a warning apparatus 540 that issues a warning to a driver based on a determination result of the collision determining unit 518. For example, when it is found that the possibility of a collision is high as a determination result of the collision determining unit 518, the ECU 530 performs vehicle control involving applying the brakes, releasing the gas pedal, suppressing engine output, or the like to avoid a collision and/or reduce damage. The warning apparatus 540 issues a warning to a user by sounding an alarm, displaying warning information on a screen of a car navigation system or the like, vibrating a seat belt or a steering wheel, or the like.

In the present embodiment, an image of a periphery of the vehicle such as the front or the rear of the vehicle is picked up by the photoelectric conversion system 500. FIG. 12B shows the photoelectric conversion system when imaging of the front of the vehicle (an imaging range 550) is performed. The vehicle information acquiring apparatus 520 sends an instruction to the photoelectric conversion system 500 or the imaging apparatus 510. According to such a configuration, accuracy of ranging can be further improved.

While an example of controlling a vehicle so as to prevent a collision with another vehicle has been described above, the photoelectric conversion system can also be applied to controlling automated driving so that the vehicle follows another vehicle, controlling automated driving so that the vehicle stays within a lane, and the like. In addition, the photoelectric conversion system is not limited to a vehicle such as an automobile and can also be applied to a moving body (moving apparatus) such as a ship, an airplane, or an industrial robot. The moving body includes one of or both of a driving force generating unit that generates a driving force mainly used for movement of the moving body and a rotating member that is mainly used for movement of the moving body. The driving force generating unit can be an engine, a motor, or the like. The rotating member can be a tire, a wheel, a screw of a ship, a propeller of a flight vehicle, or the like. Moreover, besides moving bodies, the photoelectric conversion system can be applied to a wide variety of apparatuses that utilize object recognition such as an intelligent transportation system (ITS).

### Sixth Embodiment

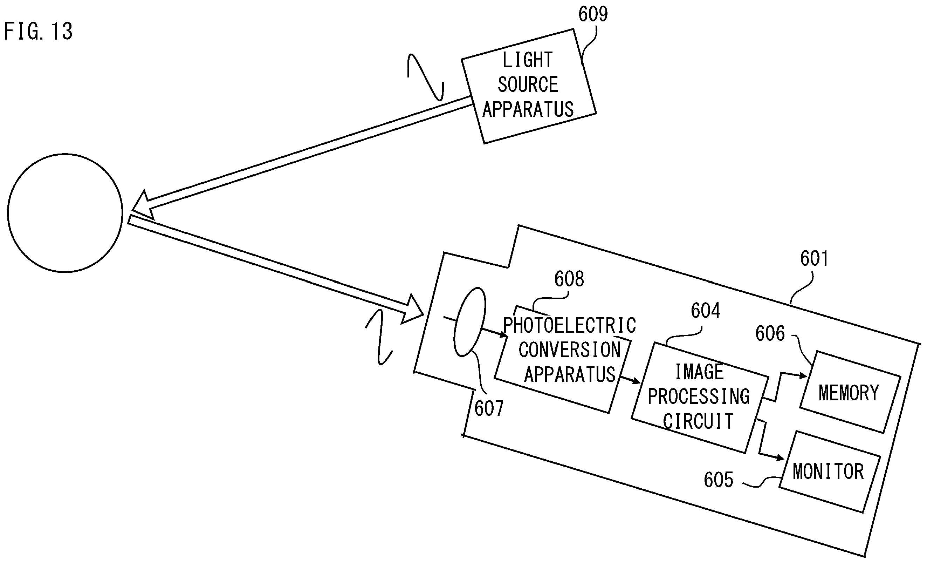

A photoelectric conversion system according to the present embodiment will be described with reference to FIG. 13. FIG. 13 is a block diagram showing a configuration example of a distance image sensor that is the photoelectric conversion system according to the present embodiment.

As shown in FIG. 13, a distance image sensor 601 is configured to include an optical system 607, a photoelectric conversion apparatus 608, an image processing circuit 604, a monitor 605, and a memory 606. In addition, the distance image sensor 601 is capable of acquiring a distance image in accordance with a distance to a subject by receiving light (modulated light or pulsed light) emitted toward the subject from a light source apparatus 609 and reflected by a surface of the subject.

The optical system 607 is configured with one or a plurality of lenses and guides image light (incident light) from the subject to the photoelectric conversion apparatus 608 and forms an image on a light-receiving surface (a sensor unit) of the photoelectric conversion apparatus 608.

The image processing circuit 604 performs image processing for constructing a distance image based on the distance signal supplied from the photoelectric conversion apparatus 608. In addition, a distance image (image data) obtained by the image processing is supplied to and displayed by the monitor 605 or supplied to and stored (recorded) in the memory 606.

With the distance image sensor 601 configured as described above, applying one of the photoelectric conversion apparatuses described above enables, for example, a more accurate distance image to be acquired due to an improvement in ranging accuracy.

### Seventh Embodiment

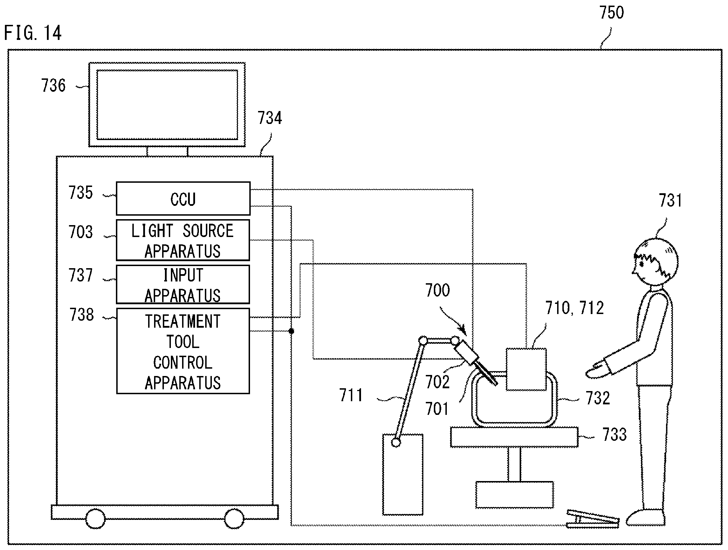

A photoelectric conversion system according to the present embodiment will be described with reference to FIG. 14. FIG. 14 is a diagram showing an example of a schematic configuration of an endoscopic surgery system that is the photoelectric conversion system according to the present embodiment.

FIG. 14 illustrates a situation where a technician (a physician) 731 is using an endoscopic surgery system 750 to operate on a patient 732 on a patient bed 733. As illustrated, the endoscopic surgery system 750 is constituted of an endoscope 700, a surgical instrument 710, and a cart 734 mounted with various apparatuses for an endoscopic surgery.

The endoscope 700 is constituted of a lens barrel 701 of which a region with a predetermined length from a distal end is to be inserted into a body cavity of the patient 732 and a camera head 702 connected to a base end of the lens barrel 701. While the illustrated example features the endoscope 700 being configured as a so-called rigid scope having a rigid lens barrel 701, alternatively, the endoscope 700 may be configured as a so-called flexible scope having a flexible lens barrel.

An opening into which an objective lens is fitted is provided at the distal end of the lens barrel 701. A light source apparatus 703 is connected to the endoscope 700, and light generated by the light source apparatus 703 is guided to the distal end of the lens barrel 701 by a light guide provided so as to extend inside the lens barrel and emitted toward an observation object inside a body cavity of the patient 732 via the objective lens. It should be noted that the endoscope 700 may be a forward-viewing endoscope, an oblique-viewing endoscope, or a side-viewing endoscope.

An optical system and a photoelectric conversion apparatus are provided inside the camera head 702 and reflected light (observation light) from the observation object is collected to the photoelectric conversion apparatus by the optical system. The observation light is photoelectrically converted by the photoelectric conversion apparatus and an electric signal corresponding to the observation light or, in other words, an image signal corresponding to an observed image is generated. As the photoelectric conversion apparatus, the photoelectric conversion apparatus according to any one of the embodiments described above can be used. The image signal is transmitted to a Camera Control Unit (CCU) 735 as RAW data.

The CCU 735 is constituted of a CPU (Central Processing Unit), a GPU (Graphics Processing Unit), or the like and comprehensively controls operations of the endoscope 700 and a display apparatus 736. In addition, the CCU 735 receives an image signal from the camera head 702 and subjects the image signal to various kinds of image processing for displaying an image based on the image signal such as development processing (demosaicing).

Under control exerted by the CCU 735, the display apparatus 736 displays an image based on the image signal subjected to image processing by the CCU 735. The light source apparatus 703 is constituted of a light source such as an LED (Light-Emitting Diode) and supplies the endoscope 700 with irradiation light used when photographing a surgical site or the like.

An input apparatus 737 is an input interface with respect to the endoscopic surgery system 750. A user can input various kinds of information and input instructions to the endoscopic surgery system 750 via the input apparatus 737.

A treatment tool control apparatus 738 controls drive of an energy treatment tool 712 for cauterizing or incising tissue, sealing a blood vessel, or the like. The light source apparatus 703 that supplies the endoscope 700 with irradiation light when photographing a surgical site can be constituted of a white light source constituted of an LED, a laser light source, or a combination thereof. When the white light source is constituted of a combination of RGB laser light sources, since output intensity and an output timing of each color (each wavelength) can be controlled with high accuracy, white balance of a captured image can be adjusted in the light source apparatus 703. In addition, in this case, an image corresponding to each of RGB can be captured in a time-divided manner by having an observation object be irradiated with laser light from each of the RGB laser light sources in a time-divided manner and controlling drive of an imaging element of the camera head 702 in synchronization with the irradiation timing. According to this method, a color image can be obtained without having to provide the imaging element with a color filter.

In addition, drive of the light source apparatus 703 may be controlled such that intensity of output light changes at predetermined intervals. By controlling drive of imaging elements of the camera head 702 in synchronization with a timing at which the intensity of light changes to acquire images in a time-divided manner and compositing the images, an image with a high dynamic range that is free of so-called blocked-up shadows and blown-out highlights can be generated.

Furthermore, the light source apparatus 703 may be configured to be capable of supplying light in a predetermined wavelength band that accommodates special light observation. In special light observation, for example, wavelength dependence of absorption of light by body tissue is utilized. Specifically, predetermined tissue such as a blood vessel of a superficial portion of a mucous membrane is photographed with high contrast by irradiating light with a narrower band than irradiation light during normal observation (in other words, white light). Alternatively, in special light observation, fluorescent observation may be performed in which an image is obtained using fluorescent light generated by irradiating excitation light. In fluorescent observation, body tissue may be irradiated with excitation light and fluorescent light from the body tissue can be observed, a reagent such as indocyanine green (ICG) can be locally injected into body tissue and the body tissue can be irradiated with excitation light corresponding to a fluorescent wavelength of the reagent to obtain a fluorescent image, and the like. The light source apparatus 703 may be configured to be capable of supplying narrow-band light and/or excitation light that accommodates such special light observation.

### Eighth Embodiment

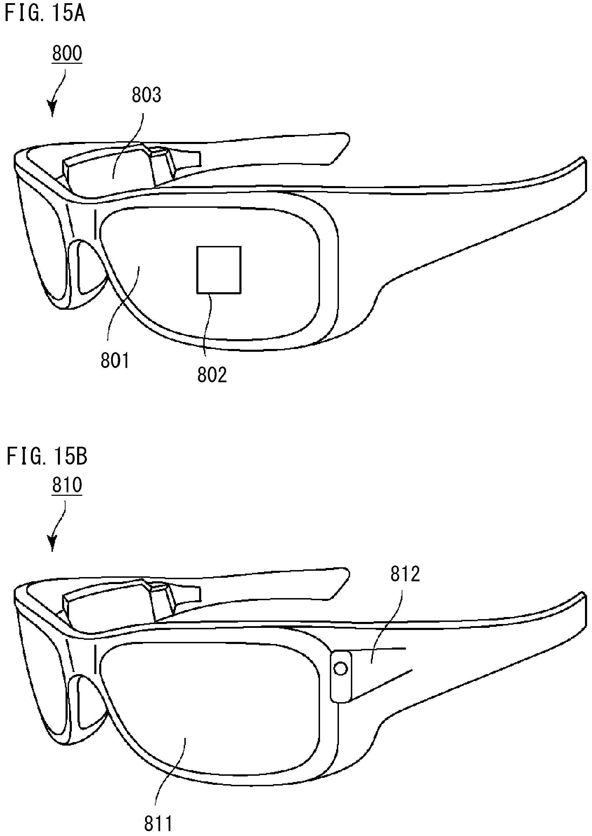

A photoelectric conversion system according to the present embodiment will be described with reference to FIGS. 15A and 15B. FIG. 15A illustrates eyeglasses 800 (smart glasses) that is the photoelectric conversion system according to the present embodiment. The eyeglasses 800 have a photoelectric conversion apparatus 802. The photoelectric conversion apparatus 802 is the photoelectric conversion apparatus according to any one of the embodiments described above. In addition, a display apparatus including a light-emitting apparatus such as an OLED or an LED may be provided on a rear surface side of a lens 801. There may be one or a plurality of photoelectric conversion apparatuses 802. Alternatively, a plurality of types of photoelectric conversion apparatuses may be used in combination. An arrangement position of the photoelectric conversion apparatus 802 is not limited to that shown in FIG. 15A.

The eyeglasses 800 further include a control apparatus 803. The control apparatus 803 functions as a power source that supplies power to the photoelectric conversion apparatus 802 and the display apparatus described above. In addition, the control apparatus 803 controls operations of the photoelectric conversion apparatus 802 and the display apparatus. An optical system for collecting light to the photoelectric conversion apparatus 802 is formed in the lens 801.

FIG. 15B illustrates eyeglasses 810 (smart glasses) according to one application example. The eyeglasses 810 include a control apparatus 812 and the control apparatus 812 is mounted with a photoelectric conversion apparatus that corresponds to the photoelectric conversion apparatus 802 and a display apparatus. An optical system for projecting light emitted from the photoelectric conversion apparatus inside the control apparatus 812 and the display apparatus is formed in the lens 811 and an image is projected onto the lens 811. The control apparatus 812 functions as a power source that supplies power to the photoelectric conversion apparatus and the display apparatus and, at the same time, controls operations of the photoelectric conversion apparatus and the display apparatus. The control apparatus may have a line-of-sight detecting unit that detects a line-of-sight of a wearer. Infrared light may be used to detect a line-of-sight. An infrared light-emitting unit emits infrared light to the eyes of a user who is looking at a display image. A picked-up image of the eyes can be obtained by having an imaging unit including a light-receiving element detect reflected light from the eyes of emitted infrared light. Providing reducing means that reduces light from the infrared light-emitting unit to the display unit in a plan view enables a decline in image quality to be mitigated.

A line-of-sight of the user with respect to a display image can be detected from a picked-up image of eyes obtained by imaging with infrared light. Any known method can be applied to line-of-sight detection using a picked-up image of the eyes. For example, a line-of-sight detection method based on a Purkinje image due to reflection of irradiation light by the cornea can be used.

More specifically, line-of-sight detection processing based on a pupil-corneal reflection method is performed. Using the pupil-corneal reflection method, a line-of-sight of a user is detected by calculating a line-of-sight vector that represents an orientation (a rotation angle) of the eyes based on an image of a pupil included in a picked-up image of the eyes and a Purkinje image. The display apparatus according to the present embodiment may have a photoelectric conversion apparatus including a light-receiving element and a display image of the display apparatus may be controlled based on line-of-sight information of the user from the photoelectric conversion apparatus.

Specifically, the display apparatus determines, based on the line-of-sight information, a first field-of-view region which the user focuses on and a second field-of-view region other than the first field-of-view region. The first field-of-view region and the second field-of-view region may be determined by the control apparatus of the display apparatus or regions determined by an outside control apparatus may be received as the first field-of-view region and the second field-of-view region. In a display region of the display apparatus, a display resolution of the first field-of-view region may be controlled to be higher than a display resolution of the second field-of-view region. In other words, the resolution of the second field-of-view region may be set lower than that of the first field-of-view region.

In addition, the display region may have a first display region and a second display region that differs from the first display region, and a region with high priority may be determined from the first display region and the second display region based on line-of-sight information. The first display region and the second display region may be determined by the control apparatus of the display apparatus or regions determined by an outside control apparatus may be received as the first display region and the second display region. A resolution of a region with high priority may be controlled to be higher than a resolution of a region other than the region with high priority. In other words, a resolution of a region of which a priority is relatively low can be lowered.

It should be noted that an AI (Artificial Intelligence) may be used to determine the first field-of-view region and a region with high priority. The AI may be a model configured to use an image of the eyes and a direction actually viewed by the eyes in the image as teacher data to estimate, from the image of the eyes, an angle of a line-of-sight and a distance to an object ahead of the line-of-sight. An AI program may be included in the display apparatus, the photoelectric conversion apparatus, or an external apparatus. When the external apparatus includes an AI program, an inference result by an AI is sent to the display apparatus via communication.

Display control based on visual recognition and detection can be preferably applied to smart glasses further including a photoelectric conversion apparatus that captures images of the outside. The smart glasses are capable of displaying captured external information in real-time.

### Ninth Embodiment

The photoelectric conversion apparatuses and the photoelectric conversion systems described above can be applied to, for example, electronic devices such as so-called smartphones and tablets.

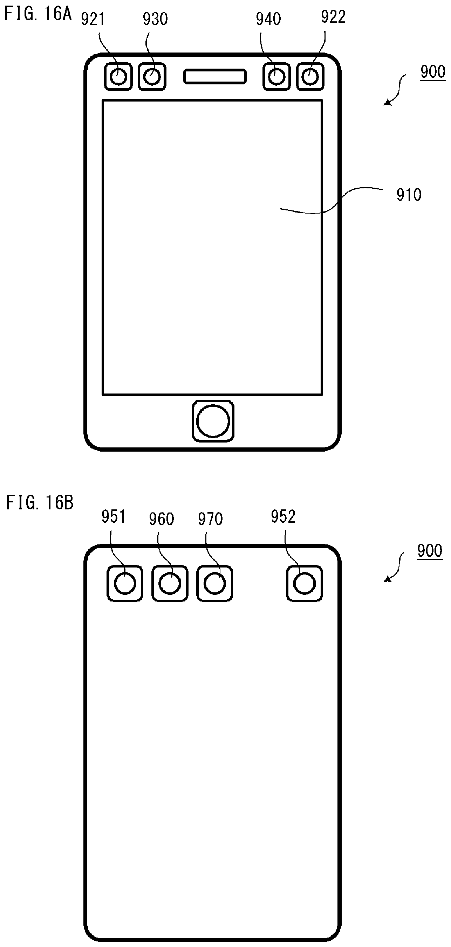

FIGS. 16A and 16B are diagrams showing an example of an electronic device 900 to which a photoelectric conversion apparatus is mounted. FIG. 16A shows a front surface side of the electronic device 900 and FIG. 16B shows a rear surface side of the electronic device 900.

As shown in FIG. 16A, a display 910 that displays an image is arranged at a center of the front surface of the electronic device 900. In addition, front cameras 921 and 922 that use the photoelectric conversion apparatus, an IR light source 930 that emits infrared light, and a visible light source 940 that emits visible light are arranged along an upper side of the front surface of the electronic device 900.

Furthermore, as shown in FIG. 16B, rear cameras 951 and 952 that use the photoelectric conversion apparatus, an IR light source 960 that emits infrared light, and a visible light source 970 that emits visible light are arranged along an upper side of the rear surface of the electronic device 900.

In the electronic device 900 configured as described above, by applying the photoelectric conversion apparatus described above, for example, an image with higher quality can be captured and a distance to a subject can be measured with high accuracy. Note that the photoelectric conversion apparatus can be applied to other electronic devices such as an infrared sensor, a ranging sensor using an active infrared light source, a security camera, and a personal authentication camera or a biometric camera. As a result, accuracy and performance of such electronic devices can be improved.

### Tenth Embodiment

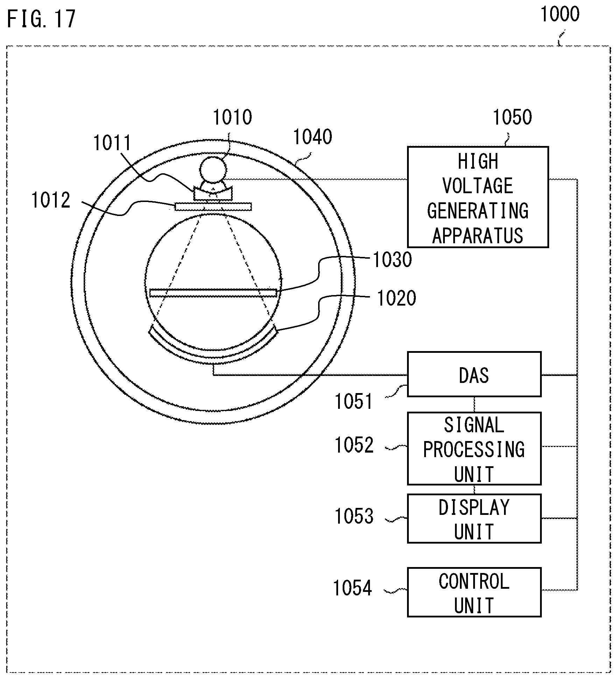

FIG. 17 is a block diagram of an X-ray CT apparatus according to the present embodiment. The photoelectric conversion apparatuses and the photoelectric conversion systems described above can be applied to a detector of the X-ray CT apparatus. An X-ray CT apparatus 1000 according to the present embodiment includes an X-ray generating unit 1010, a wedge 1011, a collimator 1012, an X-ray detecting unit 1020, and a top plate 1030. Furthermore, the X-ray CT apparatus 1000 includes a rotating frame 1040, a high voltage generating apparatus 1050, a data collection apparatus (DAS: Data Acquisition System) 1051, a signal processing unit 1052, a display unit 1053, and a control unit 1054.

The X-ray generating unit 1010 is constituted of, for example, a vacuum tube that generates X-rays. A high voltage from the high voltage generating apparatus 1050 and a filament current are supplied to the vacuum tube of the X-ray generating unit 1010. An X-ray is generated as thermions are radiated from a cathode (filament) toward an anode (target).

The wedge 1011 is a filter that adjusts an X-ray dosage radiated from the X-ray generating unit 1010. The wedge 1011 attenuates the X-ray dosage so that X-rays radiated from the X-ray generating unit 1010 toward the object are distributed as determined in advance. The collimator 1012 is constituted of a lead plate or the like that narrows down an irradiation range of the X-rays having passed through the wedge 1011. An X-ray generated by the X-ray generating unit 1010 is molded into a cone beam shape via the collimator 1012 and radiated to the object on the top plate 1030.

The X-ray detecting unit 1020 is constructed by using the photoelectric conversion apparatus or the photoelectric conversion system described above. The X-ray detecting unit 1020 detects an X-ray having passed through the object from the X-ray generating unit 1010 and outputs a signal corresponding to the X-ray dosage to the DAS 1051.

The rotating frame 1040 has an annular shape and is configured to be rotatable. The X-ray generating unit 1010 (the wedge 1011 and the collimator 1012) and the X-ray detecting unit 1020 are arranged so as to oppose each other inside the rotating frame 1040. The X-ray generating unit 1010 and the X-ray detecting unit 1020 are rotatable together with the rotating frame 1040.

The high voltage generating apparatus 1050 includes a boost circuit and outputs a high voltage to the X-ray generating unit 1010. The DAS 1051 includes an amplifier circuit and an A/D converter circuit and outputs a signal from the X-ray detecting unit 1020 as digital data to the signal processing unit 1052.

The signal processing unit 1052 includes a CPU (Central Processing Unit), a ROM (Read Only Memory), and a RAM (Random Access Memory) and is capable of executing image processing of digital data and the like. The display unit 1053 includes a flat display apparatus or the like and is capable of displaying an X-ray image. The control unit 1054 includes a CPU, a ROM, and a RAM and controls operations of the entire X-ray CT apparatus 1000.

### Eleventh Embodiment

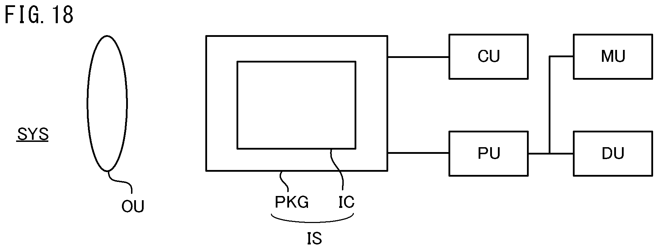

A photoelectric conversion system according to an eleventh embodiment will be described with reference to FIG. 18. FIG. 18 is a block diagram showing a schematic configuration of an imaging system SYS that is the photoelectric conversion system according to the eleventh embodiment. The imaging system SYS includes at least the photoelectric conversion apparatus according to any one of the embodiments described above and a signal processing unit that processes signals output from the photoelectric conversion apparatus.

The imaging system SYS is an information terminal that includes a camera and a photography function. The imaging system SYS is constructed using an imaging apparatus IS. The imaging apparatus IS can further include a package PKG that houses an imaging device IC. The package PKG can include a substrate on which the imaging device IC is fixed and a lid body that opposes the imaging device IC. The package PKG can include a connecting member (a member that connects a terminal provided on the substrate and a terminal provided on the imaging device IC) to each other. The imaging apparatus IS can mount a plurality of the imaging devices IC to a common package PKG by arranging the imaging devices IC side by side. Alternatively, the imaging apparatus IS can mount the imaging device IC and another semiconductor device IC to a common package PKG by stacking the imaging device IC and the semiconductor device IC on top of each other.

The imaging system SYS can include an optical system OU (optical apparatus) that forms an image on the imaging apparatus IS. In addition, the imaging system SYS can include at least any of a control apparatus CU, a processing apparatus PU, a display apparatus DU, and a storage apparatus MU. The control apparatus CU controls the imaging apparatus IS and the processing apparatus PU processes a signal obtained from the imaging apparatus IS. Furthermore, the display apparatus DU displays an image obtained from the imaging apparatus IS and the storage apparatus MU stores the image obtained from the imaging apparatus IS.

### Other Embodiments

While various apparatuses have been explained in the embodiments described above, a mechanical apparatus may be further provided. A mechanical apparatus in a camera can drive parts of the optical system for the purposes of zooming, focusing, and shutter operations. Alternatively, the mechanical apparatus in the camera can move the photoelectric conversion apparatus for vibration insulation.

In addition, the apparatus may be transportation equipment such as a vehicle, a ship, or a flight vehicle. A mechanical apparatus in the transportation equipment may be used as a moving apparatus. The apparatus as transportation equipment is suitable as an apparatus that transports the photoelectric conversion apparatus or an apparatus that assists and/or automates driving (operation) using the photography function. A processing apparatus for assisting and/or automating driving (operation) can perform processing for operating the mechanical apparatus as a moving apparatus based on information obtained by the photoelectric conversion apparatus.

The embodiments described above can be appropriately modified without departing from the technical concepts of the invention. It is to be understood that disclosed contents of the present specification include not only matters described in the present specification but also all matters that may be comprehended from the present specification and from the drawings that accompany the present specification. In addition, disclosed contents of the present specification include complementary sets of concepts described in the present specification. In other words, supposing that the present specification includes a description reading, for example, "A is larger than B", it is assumed that the present specification also discloses that "A is not larger than B" even though a description of "A is not larger than B" has been omitted. This is because, the presence of a description to the effect that "A is larger than B" is premised on the fact that a case where "A is not larger than B" is being taken into consideration.

In the present specification, there may be cases where expressions such as "A or B", "at least one of A and B", "at least one of A and/or B", "one or more of A and/or B", and the like are used. In such a case, all possible combinations of the listed items can be included unless explicitly defined otherwise. In other words, the expressions presented above are understood to disclose all of a case where at least one A is included, a case where at least one B is included, and a case where both at least one A and at least one B are included. This logic is similarly applied to combinations of three or more elements.

According to the technology of the present disclosure, it is possible to provide a technology for supporting microfabrication of circuits in photoelectric conversion apparatuses having a structure of at least three layers.

While the present invention has been described with reference to exemplary embodiments, it is to be understood that the invention is not limited to the disclosed exemplary embodiments. The scope of the following claims is to be accorded the broadest interpretation so as to encompass all such modifications and equivalent structures and functions.

## Claims

1. A photoelectric conversion apparatus comprising:
a pixel having an avalanche photodiode, a pixel circuit that performs processing using a signal output from the avalanche photodiode, and a signal processing circuit that performs processing using a signal output from the pixel circuit; and
a control signal generation circuit that generates a first control signal to control an operation of the pixel circuit and a second control signal to control an operation of the signal processing circuit, wherein
a second circuit layer where the signal processing circuit and the control signal generation circuit are arranged, a first circuit layer where the pixel circuit is arranged, and a photodiode layer where the avalanche photodiode is arranged are laminated together in this order,
an output terminal of the avalanche photodiode is connected to the pixel circuit,
the pixel is provided in plurality and arranged in a pixel region,
the control signal generation circuit is arranged in a peripheral region provided around the pixel region, and
first wiring that supplies the first control signal to the pixel circuit is provided on the first circuit layer, the first wiring being connected to the control signal generation circuit in the peripheral region.

2. The photoelectric conversion apparatus according to claim 1, wherein,
in the pixel region, buffers are arranged on the first wiring at a fixed pitch according to a pixel unit.

3. The photoelectric conversion apparatus according to claim 1 or 2, wherein
the plurality of pixels include at least one pixel where a buffer is not provided on the first wiring and at least one pixel where a buffer is provided on the first wiring.

4. The photoelectric conversion apparatus according to any one of claims 1 to 3, wherein,
in the pixel region, the first wiring is provided on the first circuit layer.

5. The photoelectric conversion apparatus according to any one of claims 1 to 4, wherein,
in the pixel region, second wiring that supplies the second control signal to the signal processing circuit is provided on the second circuit layer.

6. The photoelectric conversion apparatus according to any one of claims 1 to 5, wherein
an element arranged on the first circuit layer is an element having higher pressure resistance than an element arranged on the second circuit layer.

7. The photoelectric conversion apparatus according to any one of claims 1 to 6, wherein
the pixel circuit includes a control circuit for the avalanche photodiode, and
the signal processing circuit includes a count circuit that performs count processing for the signal output from the pixel circuit.

8. The photoelectric conversion apparatus according to any one of claims 1 to 7, wherein
the pixel circuit includes a quenching element that performs a quenching operation for the avalanche photodiode and a waveform shaping circuit that performs waveform shaping processing for the signal output from the avalanche photodiode.

9. The photoelectric conversion apparatus according to claim 8, wherein
the quenching element is controlled by the first control signal to switch between a high-resistance state and a low-resistance state where a resistance value is lower than a resistance value of the high-resistance state.

10. The photoelectric conversion apparatus according to claim 7, wherein
the count circuit has a flip-flop that performs the count processing and a memory that retains a count value obtained through the count processing.

11. The photoelectric conversion apparatus according to any one of claims 1 to 10, wherein,
on the first wiring, a first buffer that outputs the first control signal to a plurality of groups each including at least two pixels among the plurality of pixels and a second buffer that outputs the first control signal to the respective pixels included in the plurality of groups are arranged.

12. The photoelectric conversion apparatus according to claim 11, wherein
the first buffer has a logic circuit that inverts the first control signal that is to be input.

13. A photoelectric conversion system comprising:
the photoelectric conversion apparatus according to any one of claims 1 to 12; and
a signal processing unit that generates an image using a signal output from the photoelectric conversion apparatus.

14. A moving body having the photoelectric conversion apparatus according to any one of claims 1 to 12, the moving body comprising:
a control unit that controls movement of the moving body using a signal output from the photoelectric conversion apparatus.

15. Equipment comprising the photoelectric conversion apparatus according to any one of claims 1 to 12, the equipment further comprising at least any of:
an optical apparatus corresponding to the photoelectric conversion apparatus;
a control apparatus that controls the photoelectric conversion apparatus;
a processing apparatus that processes a signal output from the photoelectric conversion apparatus;
a display apparatus that displays information obtained by the photoelectric conversion apparatus;
a storage apparatus that stores information obtained by the photoelectric conversion apparatus; and
a mechanical apparatus that operates on a basis of information obtained by the photoelectric conversion apparatus.
